# EUROPEAN PATENT APPLICATION

(11) **EP 4 626 188 A1**
(43) Date of publication of application: **01.10.2025**
(21) Application number: 25164330.0
(22) Date of filing: 18.03.2025
(51) Int. Cl.: H10H 29/14, H10H 29/851, H10H 29/80, H01L 25/16, H10H 20/811, H10H 20/813

(54) **LIGHT SOURCE, LIGHT-EMITTING MODULE, AND MOBILE TERMINAL**

(30) Priority: 27.03.2024 JP 2024050994; 23.01.2025 JP 2025009598
(71) Applicant: Nichia Corporation, Anan-shi, Tokushima 774-8601 (JP)
(72) Inventor: SAKATA, Akio, Anan-shi, Tokushima, 774-8601 (JP); OKAHISA, Tsuyoshi, Anan-shi, Tokushima, 774-8601 (JP)
(74) Representative: Betten & Resch

(57) **Abstract**

A light source includes: a light-emitting element including: a first light-emitting part configured to emit first light, and a second light-emitting part configured to emit second light having a peak emission wavelength different from a peak emission wavelength of the first light, wherein: the first light-emitting part and the second light-emitting part are stacked in a first direction; and a wavelength conversion member disposed on the light-emitting element, the wavelength conversion member including: a first phosphor layer configured to be excited by the first light and emit third light, and a second phosphor layer configured to be excited by the second light and emit fourth light having a peak emission wavelength different from a peak emission wavelength of the third light, wherein: the first phosphor layer and the second phosphor layer are stacked in the first direction.

## Description

### TECHNICAL FIELD

The present disclosure relates to a light source, a light-emitting module, and a mobile terminal.

### BACKGROUND

Light sources are known that can adjust the color of mixed-color light, which includes light emitted from a plurality of light-emitting regions. Japanese Patent Publication No. 2020-27814 describes a light-emitting diode (LED) light source including a substrate, a plurality of first LED dies and second LED dies mounted on the substrate, a white reflective resin filled between the first LED dies and the second LED dies, a first fluorescent resin covering each of the first LED dies, a second fluorescent resin covering each of the second LED dies, and a transparent resin covering the white reflective resin, the first fluorescent resin, and the second fluorescent resin.

### SUMMARY

An object of an embodiment of the present disclosure is to reduce the size of a light source that can adjust the color of mixed-color light.

A light source according to one embodiment of the present disclosure includes: a light-emitting element including a first light-emitting part configured to emit first light and a second light-emitting part configured to emit second light having a peak emission wavelength different from a peak emission wavelength of the first light, the first light-emitting part and the second light-emitting part being stacked in a first direction and each including a first semiconductor layer, a light-emitting layer, and a second semiconductor layer; and a wavelength conversion member disposed on the light-emitting element, and including a first phosphor layer configured to be excited by the first light and emit third light and a second phosphor layer configured to be excited by the second light and emit fourth light having a peak emission wavelength different from a peak emission wavelength of the third light, the first phosphor layer and the second phosphor layer being stacked in the first direction.

A light-emitting module according to one embodiment of the present disclosure includes: a first light source; and a lens disposed above the first light source, wherein the first light source includes a first light-emitting element including a first light-emitting part configured to emit first light and a second light-emitting part configured to emit second light having a peak emission wavelength different from a peak emission wavelength of the first light, the first light-emitting part and the second light-emitting part being stacked in a first direction and each including a first semiconductor layer, a light-emitting layer, and a second semiconductor layer, and a first wavelength conversion member disposed on the first light-emitting element, and including a first phosphor layer configured to be excited by the first light and emit third light and a second phosphor layer configured to be excited by the second light and emit fourth light having a peak emission wavelength different from a peak emission wavelength of the third light, the first phosphor layer and the second phosphor layer being stacked in the first direction.

A mobile terminal according to one embodiment of the present disclosure includes: an imaging element configured to capture an image of a subject; and a light-emitting module configured to emit irradiation light on the subject, wherein the light-emitting module includes a first light source, and a lens disposed above the first light source, and the first light source includes first light-emitting element including a first light-emitting part configured to emit first light and a second light-emitting part configured to emit second light having a peak emission wavelength different from a peak emission wavelength of the first light, the first light-emitting part and the second light-emitting part being stacked in a first direction and each including a first semiconductor layer, a light-emitting layer, a second semiconductor layer, and a first wavelength conversion member disposed on the first light-emitting element, and including a first phosphor layer configured to be excited by the first light and emit third light and a second phosphor layer configured to be excited by the second light and emit fourth light having a peak emission wavelength different from a peak emission wavelength of the third light, the first phosphor layer and the second phosphor layer being stacked in the first direction.

### BRIEF DESCRIPTION OF THE DRAWINGS

FIG. 1 is a top view schematically illustrating the upper surface of a mobile terminal according to a first embodiment;
FIG. 2 is a cross-sectional view schematically illustrating a light-emitting module taken through line II-II of FIG. 1;
FIG. 3A is a graph illustrating an excitation spectrum of each of a YAG-based phosphor, a SCASN-based phosphor, a KSF-based phosphor, and a CCA-based phosphor;
FIG. 3B is a graph illustrating an emission spectrum of each of the YAG-based phosphor, the SCASN-based phosphor, the KSF-based phosphor, and the CCA-based phosphor;
FIG. 4A is a graph illustrating a simulation result when only a first light-emitting part of a light source was caused to emit light in Example 1;
FIG. 4B is a graph illustrating a simulation result when only a second light-emitting part of the light source was caused to emit light in Example 1;
FIG. 5A is a graph illustrating a simulation result when only the first light-emitting part of the light source was caused to emit light in Example 2;
FIG. 5B is a graph illustrating a simulation result when only the second light-emitting part of the light source was caused to emit light in Example 2;
FIG. 6A is a graph illustrating a simulation result when only the first light-emitting part of the light source was caused to emit light in Example 3;
FIG. 6B is a graph illustrating a simulation result when only the second light-emitting part of the light source was caused to emit light in Example 3;
FIG. 7A is a graph illustrating a simulation result when only the first light-emitting part of the light source was caused to emit light in Example 4;
FIG. 7B is a graph illustrating a simulation result when only the second light-emitting part of the light source was caused to emit light in Example 4;
FIG. 8 is a top view schematically illustrating the upper surface of a light-emitting module according to a second embodiment; and
FIG. 9 is a schematic cross-sectional view of the light-emitting module according to the second embodiment, taken through line IX-IX of FIG. 8.

### DETAILED DESCRIPTION

Light sources, light-emitting modules, and a mobile terminal according to embodiments of the present disclosure will be described in detail with reference to the accompanying drawings. The embodiments described below exemplify the light sources, the light-emitting modules, and the mobile terminal to embody the technical ideas behind the present disclosure, but the present disclosure is not limited to the described embodiments. In addition, unless otherwise specified, the dimensions, materials, shapes, relative arrangements, and the like of components described in the embodiments are not intended to limit the scope of the present invention thereto, but rather are described as examples. The sizes, positional relationships, and the like of members illustrated in the drawings may be exaggerated for a better understanding of the structures. Further, in the following description, the same names and reference numerals denote the same or similar members, and a detailed description thereof will be omitted as appropriate. An end view illustrating only a cut surface may be used as a cross-sectional view.

In the drawings, directions may be indicated by an X-axis, a Y-axis, and a Z-axis. The X-axis, the Y-axis, and the Z-axis are orthogonal to one another. In the present specification, a direction along the Z-axis is referred to as a "first direction Z." A direction along the X-axis is referred to as a "second direction X." A direction along the Y-axis is referred to as a "third direction Y." A direction indicated by the arrow of the first direction Z is referred to as an upward direction, a direction opposite to the direction indicated by the arrow is referred to as a downward direction. In the first direction Z, a surface of an object when viewed from above is referred to as an "upper surface" and a surface of the object when viewed from below is referred to as a "lower surface." Further, in the present specification, the term "top view" refers to viewing an object from above in the first direction Z. However, these directions are used for convenience of description, and do not limit the orientations of the light sources, the light-emitting modules, and the mobile terminal during use. The orientations of the light sources, the light-emitting modules, and the mobile terminal are arbitrary. In the embodiments described below, each of "along the first direction Z," "along the second direction X," and "along the third direction Y" includes a case where an object is at an inclination within a range of ±10° with respect to the corresponding one of the axes. Further, in the embodiments, the term "orthogonal" may include a deviation within ±10° of 90°.

Further, in the present disclosure, unless otherwise specified, the term "polygonal shape" such as a rectangular shape encompasses polygonal shapes in which corners of the polygonal shapes are rounded, chamfered, beveled, coved, and the like. Furthermore, the term "polygonal shape" not only encompasses polygonal shapes in which corners (ends of sides) are modified, but also encompasses polygonal shapes in which intermediate portions of the sides are modified. In other words, shapes that are based on polygonal shapes and partially modified are construed as "polygonal shapes" as described in the present disclosure.

The same applies not only to polygonal shapes, but also to terms indicating specific shapes such as trapezoidal shapes, circular shapes, and projections and recesses. The same also applies when referring to sides forming such a shape. In other words, even if a corner or an intermediate portion of a side is modified, the "side" is construed as including the modified portion.

The term "cover" or "covering" is not limited to a case of direct contact, but also includes a case of indirectly covering a member via another member, for example. The term "disposing" is not limited to a case of direct contact, but also includes a case of indirectly disposing a member via another member, for example.

### [First Embodiment]

### <Mobile Terminal>

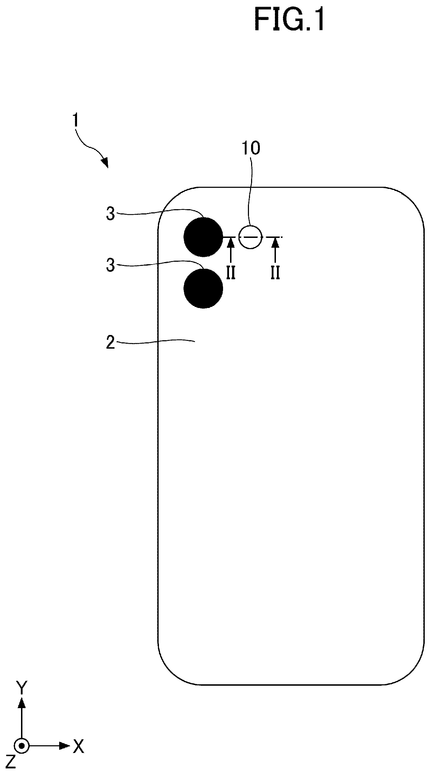

An example of an overall configuration of a mobile terminal 1 according to a first embodiment will be described with reference to FIG. 1. FIG. 1 is a top view schematically illustrating the upper surface of the mobile terminal 1 according to the first embodiment. Examples of the mobile terminal 1 include mobile devices such as a smartphone and a tablet terminal. However, the mobile terminal 1 is not limited to a smartphone or a tablet terminal.

As illustrated in FIG. 1, the mobile terminal 1 includes a housing 2, an imaging element 3, and a light-emitting module 10. The imaging element 3 functions as a part of components of a camera included in the mobile terminal 1. The imaging element 3 and the light-emitting module 10 are accommodated in, for example, adjacent spaces in the housing 2. The imaging element 3 and the light-emitting module 10 are disposed on the upper surface side of the housing 2. The mobile terminal 1 includes a display screen such as a liquid crystal display or an organic EL display on the lower surface side of the housing 2.

The imaging element 3 is configured to capture an image of a subject. The imaging element 3 is a photoelectric conversion element that receives external light including reflected light from the subject and converts a received optical signal into an electrical signal. The camera of the mobile terminal 1 can capture a still image, a moving image, or both through the electrical signal from the imaging element 3. In the example illustrated in FIG. 1, the light-emitting module 10 is used as a light-emitting module for a flash, which is configured to emit irradiation light on the subject. However, the light-emitting module 10 may be a light-emitting module used in an application other than a flash of the mobile terminal 1. For example, the light-emitting module 10 may be used as a flashlight of the mobile terminal 1 at night or in a dark place. In particular, if the light-emitting module 10 is used as a flashlight of the mobile terminal 1, the flashlight preferably has a color adjustment function because a desired color of irradiation light may vary depending on the nationality, the race, the age, and the like of a user.

### <Light-Emitting Module 10>

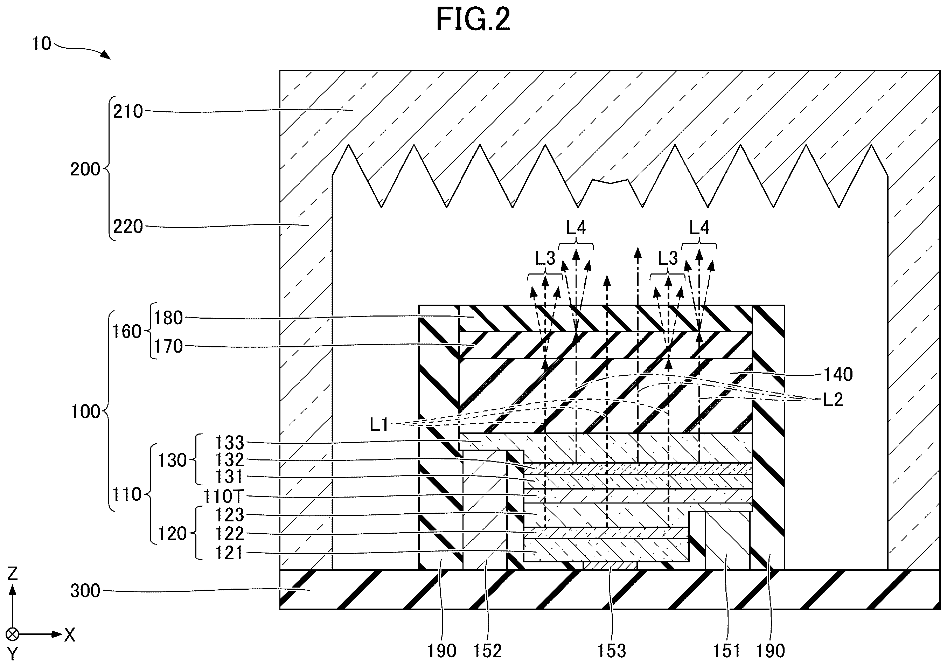

Next, an example of an overall configuration of the light-emitting module 10 according to the first embodiment will be described with reference to FIG. 2. FIG. 2 is a cross-sectional view schematically illustrating the light-emitting module 10 taken through line II-II of FIG. 1.

As illustrated in FIG. 2, the light-emitting module 10 includes a light source 100 and a lens 200. The light-emitting module 10 may further include a substrate 300 that supports the light source 100 and the lens 200. The substrate 300 is, for example, a wiring substrate including an insulating base and wiring that is disposed on at least the upper surface of the base and electrically connects the light source 100 to the an external power supply circuit. The wiring may be disposed inside the base, on the lower surface of the base, or both. Examples of the material of the insulating base include a polyimide resin, a polyester resin, a glass epoxy, a BT resin, aluminum nitride (AlN), silicon nitride (Si₃N₄), and aluminum oxide (Al₂O₃). The light-emitting module 10 may further include, on the substrate 300, an electronic circuit such as large-scale integration (LSI) that controls the light emitting operation of the light source 100. The substrate 300 may be a semiconductor substrate having a control circuit function such as an application specific integrated circuit (ASIC) that controls the light emitting operation of the light source 100.

The lens 200 includes a lens part 210 disposed above the light source 100. As illustrated in FIG. 2, the lens 200 may further include a support part 220 that supports the lens part 210. The lens part 210 and the support part 220 may be structurally monolithic members or may be separate members. Examples of the material of each of the lens part 210 and the support part 220 include a light transmissive material such as a polycarbonate resin, an acrylic resin, a silicone resin, and glass.

The lens part 210 transmits light emitted from the light source 100. The light emitted from the light source 100 and transmitted through the lens part 210 is directed to the outside of the mobile terminal 1. The lens part 210 illustrated in FIG. 2 is a lens having a Fresnel shape on the lower surface. However, the shape of the lens part 210 is not limited thereto. The lens part 210 may have another shape such as a biconvex lens or a plano-convex lens. The support part 220 has an annular shape or a frame shape surrounding the light source 100 in a top view. The lower end of the support part 220 is bonded to the upper surface of the substrate 300 directly or via a bonding member.

### <Light Source 100>

The light source 100 includes a light-emitting element 110 and a wavelength conversion member 160. As illustrated in FIG. 2, the wavelength conversion member 160 is disposed on the light-emitting element 110. The light source 100 may further include other components such as a light shielding member 190 covering the lateral surface(s) of the light-emitting element 110 and the lateral surface(s) of the wavelength conversion member 160, and a light transmissive member covering the upper surface of the wavelength conversion member 160. As used herein, "light transmissive" means having a transmittance of 60% or more and preferably 80% or more with respect to light. For convenience of description, the light transmissive member covering the upper surface of the wavelength conversion member 160 is not depicted.

### (Light-Emitting Element 110)

An example of a configuration of the light-emitting element 110 will be described. As illustrated in FIG. 2, the light-emitting element 110 includes a first light-emitting part 120 and a second light-emitting part 130. The first light-emitting part 120 and the second light-emitting part 130 are stacked in the first direction Z. In this example, a tunnel junction layer 110T is interposed between the first light-emitting part 120 and the second light-emitting part 130. The first light-emitting part 120 is configured to emit first light L1. The second light-emitting part 130 is configured to emit second light L2. The peak emission wavelength of the first light L1 is different from the peak emission wavelength of the second light L2. That is, the first light-emitting part 120 and the second light-emitting part 130 emit light of different colors. The light-emitting element 110 may further include other components such as an element substrate 140 and electrodes including a first electrode 151, a second electrode 152, and a third electrode 153.

The first light-emitting part 120 is a semiconductor structure including a first semiconductor layer 121, a light-emitting layer 122, and a second semiconductor layer 123. As illustrated in FIG. 2, the first semiconductor layer 121, the light-emitting layer 122, and the second semiconductor layer 123 are stacked in this order in the first direction Z. The first semiconductor layer 121 and the second semiconductor layer 123 are of different conductivity types. In the example illustrated in FIG. 2, the first semiconductor layer 121 is formed of a p-type semiconductor, and the second semiconductor layer 123 is formed of an n-type semiconductor. However, alternatively, the first semiconductor layer 121 may be formed of an n-type semiconductor, and the second semiconductor layer 123 may be formed of a p-type semiconductor. The first light-emitting part 120 emits the first light L1 from the light-emitting layer 122. The light-emitting layer 122 may have a single quantum well (SQW) structure or a multiple quantum well (MQW) structure including a plurality of well layers.

In the first light-emitting part, each of the first semiconductor layer 121, the light-emitting layer 122, and the second semiconductor layer 123 is formed of, for example, a nitride semiconductor. The nitride semiconductor may include a semiconductor of any composition obtained by varying the composition ratio x and y within their ranges in the chemical formula InₓAl_{y}Ga_{1-x-y}N (0 ≤ x, 0 ≤ y, x + y ≤ 1). The peak emission wavelength of the first light L1 emitted from the light-emitting layer 122 is 400 nm or more and 530 nm or less, more preferably 420 nm or more and 490 nm or less, and even more preferably 440 nm or more and 460 nm or less. The light-emitting layer 122 emits, for example, blue light as the first light L1. However, the peak emission wavelength of the first light L1 is not limited thereto. The semiconductor forming each of the first semiconductor layer 121, the light-emitting layer 122, and the second semiconductor layer 123 is not limited to the nitride semiconductor.

The second light-emitting part 130 is a semiconductor structure including a first semiconductor layer 131, a light-emitting layer 132, and a second semiconductor layer 133. As illustrated in FIG. 2, the first semiconductor layer 131, the light-emitting layer 132, and the second semiconductor layer 133 are stacked in this order in the first direction Z.

The first semiconductor layer 131 and the second semiconductor layer 133 are of different conductivity types. In the example illustrated in FIG. 2, the first semiconductor layer 131 is formed of a p-type semiconductor, and the second semiconductor layer 133 is formed of an n-type semiconductor. However, alternatively, the first semiconductor layer 131 may be formed of an n-type semiconductor, and the second semiconductor layer 133 may be formed of a p-type semiconductor. The second light L2 is emitted from the light-emitting layer 132. The light-emitting layer 132 may have a single quantum well (SQW) structure or a multiple quantum well (MQW) structure including a plurality of well layers.

In the second light-emitting part 130, each of the first semiconductor layer 131, the light-emitting layer 132, and the second semiconductor layer 133 is formed of, for example, a nitride semiconductor. The nitride semiconductor may include a semiconductor of any composition obtained by varying the composition ratio x and y within their ranges in the chemical formula InₓAl_{y}Ga_{1-x-y}N (0 ≤ x, 0 ≤ y, x + y ≤ 1). The peak emission wavelength of the second light L2 emitted from the light-emitting layer 132 is 300 nm or more and 420 nm or less, more preferably 360 nm or more and 400 nm or less, and even more preferably 370 nm or more and 390 nm or less. The light-emitting layer 132 emits, for example, ultraviolet light as the second light L2. For example, the peak emission wavelength of the second light L2 is shorter than the peak emission wavelength of the first light L1. Further, the semiconductor forming each of the first semiconductor layer 131, the light-emitting layer 132, and the second semiconductor layer 133 is not limited to the nitride semiconductor.

In the light-emitting element 110, the second light-emitting part 130 is joined to the first light-emitting part 120 with the tunnel junction layer 110T interposed therebetween. In the example illustrated in FIG. 2, the tunnel junction layer 110T contacts the upper surface of the second semiconductor layer 123 of the first light-emitting part 120 and the lower surface of the first semiconductor layer 131 of the second light-emitting part 130. The tunnel junction layer 110T includes at least one of a p-type semiconductor layer having a higher accepter concentration than the accepter concentration of the first semiconductor layer 131 or an n-type semiconductor layer having a higher donor concentration than the donor concentration of the second semiconductor layer 123. As an example, the tunnel junction layer 110T includes a p-type semiconductor layer containing magnesium (Mg) at a high concentration and an n-type semiconductor layer containing silicon (Si) at a high concentration. Accordingly, electrons and holes can be efficiently transferred.

In the light-emitting element 110, the second light-emitting part 130 is preferably located closer to the wavelength conversion member 160 than the first light-emitting part 120 is. Disposing the second light-emitting part 130 having a short peak emission wavelength closer to the wavelength conversion member 160 (that is, closer to a light extraction surface) can reduce the possibility that the second light L2 emitted from the second light-emitting part 130 is absorbed by the semiconductor layer of the first light-emitting part 120 when the second light L2 is transmitted through the first light-emitting part 120.

In the example illustrated in FIG. 2, the element substrate 140 is disposed between the second light-emitting part 130 and the wavelength conversion member 160. The element substrate 140 is light transmissive. Examples of the material of the element substrate 140 include insulating materials such as sapphire, spinel, glass, aluminum nitride, and silicon carbide. However, the material of the element substrate 140 is not limited thereto. The first light L1 and the second light L2 are transmitted through the element substrate 140 and travel toward the wavelength conversion member 160.

The first electrode 151 is connected to the second semiconductor layer 123 of the first light-emitting part 120. The second electrode 152 is connected to the second semiconductor layer 133 of the second light-emitting part 130. The third electrode 153 is connected to the first semiconductor layer 121 of the first light-emitting part 120. By selecting two electrodes from the first electrode 151, the second electrode 152, and the third electrode 153 and applying a voltage to the selected electrodes, the wavelength of light emitted from the light-emitting element 110 can be adjusted. Applying a voltage to the first electrode 151 and the third electrode 153 allows the first light-emitting part 120 to emit light. Applying a voltage to the first electrode 151 and the second electrode 152 allows the second light-emitting part 130 to emit light. Further, applying a voltage to the second electrode 152 and the third electrode 153 allows both the first light-emitting part 120 and the second light-emitting part 130 to emit light.

Examples of the material of each of the first electrode 151, the second electrode 152, and the third electrode 153 include elemental metals such as gold, silver, aluminum, nickel, rhodium, copper, titanium, platinum, palladium, molybdenum, chromium, and tungsten, and alloy materials containing these metals. However, the material of each of the first electrode 151, the second electrode 152, and the third electrode 153 is not limited thereto. Each of the first electrode 151, the second electrode 152, and the third electrode 153 may have a single-layer structure formed of a single metal material or alloy material, or may have a stacked structure in which a plurality of metal materials or alloy materials are stacked in the first direction Z.

Each of the first electrode 151, the second electrode 152, and the third electrode 153 is connected to the wiring of the substrate 300 directly or via an electrically-conductive bonding member. That is, each of the first electrode 151, the second electrode 152, and the third electrode 153 is connected to the external power supply circuit via the wiring of the substrate 300. Accordingly, the first light-emitting part 120 and the second light-emitting part 130 are connected to the power supply circuit. A control circuit included in the light-emitting module 10 can individually control the first light-emitting part 120 and the second light-emitting part 130.

The control circuit included in the light-emitting module 10 may control the light emitting operation of each of the first light-emitting part 120 and the second light-emitting part 130 such that the first light L1 and the second light L2 are emitted at the same timing, or may control the light emitting operation of each of the first light-emitting part 120 and the second light-emitting part 130 such that the first light L1 and the second light L2 are emitted at different timings, for example, alternately. The control circuit of the light-emitting module 10 may control the emission intensity of each of the first light L1 and the second light L2 by adjusting the value of a direct current supplied from the power supply circuit to each of the first light-emitting part 120 and the second light-emitting part 130. Alternatively, the control circuit of the light-emitting module 10 may control the emission intensity of each of the first light L1 and the second light L2 by adjusting the duty ratio of a pulse current supplied from the power supply circuit to each of the first light-emitting part 120 and the second light-emitting part 130.

### (Wavelength Conversion Member 160)

An example of a configuration of the wavelength conversion member 160 will be described. The wavelength conversion member 160 converts the wavelength of at least a portion of the first light L1 emitted from the first light-emitting part 120 and the wavelength of at least a portion of the second light L2 emitted from the second light-emitting part 130, thereby emitting light with different wavelengths. As illustrated in FIG. 2, the wavelength conversion member 160 includes a first phosphor layer 170 and a second phosphor layer 180. The first phosphor layer 170 and the second phosphor layer 180 are stacked in the first direction Z. The first phosphor layer 170 and the second phosphor layer 180 are disposed at a position above the light-emitting element 110 (that is, on the light extraction surface side of the light-emitting module 10) and overlapping the light-emitting element 110 in a top view.

Each of the first phosphor layer 170 and the second phosphor layer 180 includes a light transmissive base and a phosphor. Examples of the light transmissive base included in each of the first phosphor layer 170 and the second phosphor layer 180 include ceramics such as aluminum nitride, aluminum oxide, yttrium oxide, and yttrium aluminum perovskite (YAP); inorganic materials such as glass and sapphire; an organic material such as a resin including one or more of a silicone resin, a modified silicone resin, an epoxy resin, a modified epoxy resin, an acrylic resin, a phenol resin, or a hybrid resin thereof. The phosphor included in each of the first phosphor layer 170 and the second phosphor layer 180 may be included inside the light transmissive base, or may be provided in a layer on the upper surface or the lower surface of the light transmissive base.

The first phosphor layer 170 is excited by the first light L1 emitted from the first light-emitting part 120 and emits third light L3. As used herein, "the first phosphor layer 170 is excited by the first light L1 emitted from the first light-emitting part 120" does not necessarily mean that the first phosphor layer 170 is excited only by the first light L1 emitted from the first light-emitting part 120. That is, the first phosphor layer 170 may be excited by the second light L2 emitted from the second light-emitting part 130. However, in a case where the first phosphor layer 170 is also excited by the second light L2, it is preferable that, in the first phosphor layer 170, the excitation intensity at the peak emission wavelength of the second light L2 is lower than the excitation intensity at the peak emission wavelength of the first light L1.

The first phosphor layer 170 includes a first phosphor having a lower excitation intensity at the peak emission wavelength of the second light L2 than at the peak emission wavelength of the first light L1. The first phosphor layer 170 may further include a phosphor different from the first phosphor. For example, the first phosphor layer 170 may further include a phosphor having an peak emission wavelength different from the peak emission wavelength of the first phosphor. For convenience of description, one of phosphors different from the first phosphor in the first phosphor layer 170 is referred to as a "third phosphor." In a case where the first phosphor layer 170 includes a plurality of kinds of phosphors such as the first phosphor and the third phosphor, the third light L3 emitted from the first phosphor layer 170 corresponds to, for example, mixed-color light in which light emitted from the first phosphor and light emitted from the third phosphor are mixed. The first phosphor layer 170 may further include other phosphors different from the first phosphor and the third phosphor. At least one of the other phosphors is referred to as a "fourth phosphor." The first phosphor layer 170 may include the first phosphor and the fourth phosphor without including the third phosphor.

The excitation intensity of the third phosphor at the peak emission wavelength of the second light L2 may be higher than the excitation intensity of the first phosphor at the peak emission wavelength of the second light L2. In this case, the peak emission wavelength of the third phosphor is preferably longer than the peak emission wavelength of the first phosphor. This allows the wavelength range of the third light L3 emitted from the first phosphor layer 170 to be extended to the longer wavelength side of visible light. That is, the emission spectrum of the third light L3 emitted from the first phosphor layer 170 can have a peak on the longer wavelength side.

The thickness of the first phosphor layer 170 and the content of the phosphors therein can be appropriately adjusted according to a desired color temperature, chromaticity, and the like of the third light L3. As an example, the thickness of the first phosphor layer 170 is 30 µm or more and 300 µm or less. However, the thickness of the first phosphor layer 170 is not limited thereto.

The second phosphor layer 180 is excited by the second light L2 emitted from the second light-emitting part 130 and emits fourth light L4. The peak emission wavelength of the fourth light L4 is different from the peak emission wavelength of the third light L3 emitted from the first phosphor layer 170. As used herein, "the second phosphor layer 180 is excited by the second light L2 emitted from the second light-emitting part 130" does not necessarily mean that the second phosphor layer 180 is excited only by the second light L2 emitted from the second light-emitting part 130. That is, the second phosphor layer 180 may be excited by the first light L1 emitted from the first light-emitting part 120. However, in a case where the second phosphor layer 180 is also excited by the first light L1, it is preferable that, in the second phosphor layer 180, the excitation intensity at the peak emission wavelength of the first light L1 is lower than the excitation intensity at the peak emission wavelength of the second light L2.

The second phosphor layer 180 includes a second phosphor having a lower excitation intensity at the peak emission wavelength of the first light L1 than at the peak emission wavelength of the second light L2. The peak emission wavelength of the second phosphor is shorter than the peak emission wavelength of each of the first phosphor, the third phosphor, and the fourth phosphor included in the first phosphor layer 170, for example. This allows the wavelength range of the fourth light L4 emitted from the second phosphor layer 180 to be extended to the shorter wavelength side of visible light. This, in turn, allows the color of the fourth light L4 emitted from the second phosphor layer 180 to appear bluer. As a result, the color temperature range and the chromaticity range of light emitted from the light source 100 can be expanded by combining the wavelength range of the third light L3 emitted from the first phosphor layer 170 and the wavelength range of the fourth light L4 emitted from the second phosphor layer 180.

The second phosphor layer 180 may further include a phosphor different from the second phosphor. For example, the second phosphor layer 180 may further include another phosphor having a peak emission wavelength different from the peak emission wavelength of the second phosphor. In a case where the second phosphor layer 180 includes a plurality of phosphors such as the second phosphor and the other phosphor, the fourth light L4 emitted from the second phosphor layer 180 corresponds to, for example, mixed-color light in which light emitted from the second phosphor and light emitted from the other phosphor included in the second phosphor layer 180 are mixed.

The thickness of the second phosphor layer 180 and the content of the phosphors therein can be appropriately adjusted according to a desired color temperature, chromaticity, and the like of the fourth light L4. As an example, the thickness of the second phosphor layer 180 is 30 µm or more and 300 µm or less. However, the thickness of the second phosphor layer 180 is not limited thereto.

In the wavelength conversion member 160, the first phosphor layer 170 is preferably disposed closer to the light-emitting element 110 than the second phosphor layer 180 is. Accordingly, the possibility that the fourth light L4 emitted from the second phosphor layer 180 is also absorbed by excitation of the first phosphor layer 170 and the fourth light L4 cannot be extracted to the outside of the wavelength conversion member 160 can be reduced.

Examples of the phosphors included in the first phosphor layer 170 and the second phosphor layer 180 include yttrium aluminum garnet based phosphors (for example, (Y,Gd)₃(Al,Ga)₅O₁₂:Ce), lutetium aluminum garnet based phosphors (for example, Lu₃(Al,Ga) ₅O₁₂:Ce), terbium aluminum garnet based phosphors (for example, Tb₃(Al,Ga)₅O₁₂:Ce), CCA based phosphors (for example, Ca₁₀(PO₄)₆Cl₂:Eu), SAE based phosphors (for example, Sr₄Al₁₄O₂₅:Eu), chlorosilicate based phosphors (for example, Ca₈MgSi₄O₁₆Cl₂:Eu), silicate based phosphors (for example, (Ba,Sr,Ca,Mg)₂SiO₄:Eu), oxynitride based phosphors such as β-SiAlON based phosphors (for example, (Si,Al)₃(O,N)₄:Eu) and α-SiAlON based phosphors (for example, Ca(Si,Al)₁₂(O,N)₁₆:Eu), nitride based phosphors such as LSN based phosphors (for example, (La,Y)₃Si₆N₁₁:Ce), BSESN based phosphors (for example, (Ba,Sr)₂Si₅N₈:Eu), SLA based phosphors (for example, SrLiAl₃N₄:Eu), CASN based phosphors (for example, CaAlSiN₃:Eu), and SCASN based phosphors (for example, (Sr,Ca)AlSiN₃:Eu), fluoride based phosphors such as KSF based phosphors (for example, K₂SiF₆:Mn), KSAF based phosphors (for example, K₂(Si₁₋ₓAlₓ)F₆₋ₓ:Mn, where x satisfies 0 < x < 1), and MGF based phosphors (for example, 3.5MgO·0.5MgF₂·GeO₂:Mn), quantum dots having a Perovskite structure (for example, (Cs,FA,MA) (Pb,Sn) (F,Cl,Br,I)₃, where FA and MA represent formamidinium and methylammonium, respectively), II-VI quantum dots (for example, CdSe), III-V quantum dots (for example, InP), and quantum dots having a chalcopyrite structure (for example, (Ag,Cu)(In,Ga)(S,Se)₂). The phosphors included in the first phosphor layer 170 and the second phosphor layer 180 can be appropriately selected according to desired color temperatures, chromaticities, and the like of the third light L3 emitted from the first phosphor layer 170 and the fourth light L4 emitted from the second phosphor layer 180. For example, a YAG-based phosphor may be used as the first phosphor, a CCA-based phosphor may be used as the second phosphor, a SCASN-based phosphor may be used as the third phosphor, and a KSF-based phosphor may be used as the fourth phosphor.

The third light L3 emitted from the first phosphor layer 170; the fourth light L4 emitted from the second phosphor layer 180; light not absorbed by excitation of the first phosphor layer 170 and the second phosphor layer 180, of the first light L1 emitted from the first light-emitting part 120; and light not absorbed by excitation of the first phosphor layer 170 and the second phosphor layer 180, of the second light L2 emitted from the second light-emitting part 130; are emitted from the upper surface of the wavelength conversion member 160. That is, mixed-color light, in which the first light L1 and the second light L2 are mixed, is emitted from the light source 100 toward the lens 200. At this time, for example, the control circuit of the light-emitting module 10 can adjust the color of the mixed-color light emitted from light sources 100 by individually controlling the emission intensity of the first light L1 emitted from the first light-emitting part 120 and the emission intensity of the second light L2 emitted from second light-emitting part 130. The mixed-color light emitted from the light sources 100 is white light having a color temperature of 2,000 K or more and 8,000 K or less as defined in JIS 28725, for example. However, the color temperature of the mixed-color light emitted from the light source 100 is not limited thereto.

The wavelength conversion member 160 may further include another phosphor layer different from the first phosphor layer 170 and the second phosphor layer 180. For example, in a case where the other phosphor layer includes a phosphor excited by at least one of the third light L3 emitted from the first phosphor layer 170 or the fourth light L4 emitted from the second phosphor layer 180, the color temperature range or the chromaticity range of the mixed-color light emitted from the upper surface of the wavelength conversion member 160 can be further expanded.

According to the first embodiment, the light-emitting element 110 including the first light-emitting part 120 and the second light-emitting part 130 and the wavelength conversion member 160 including the first phosphor layer 170 and the second phosphor layer 180 are disposed along the first direction Z. That is, the first light-emitting part 120, the second light-emitting part 130, the first phosphor layer 170, and the second phosphor layer 180 are disposed at positions overlapping each other in a top view. Therefore, the light source 100 capable of adjusting the color of mixed-color light can be reduced in size. In addition, the optical axis of the third light L3 emitted from the first phosphor layer 170 and the optical axis of the fourth light L4 emitted from the second phosphor layer 180 approximately coincide with each other in a top view. Thus, color unevenness of the mixed-color light emitted from the light source 100 can be reduced.

### (Light Shielding Member 190)

Next, an example of a configuration of the light shielding member 190 will be described. As illustrated in FIG. 2, the light shielding member 190 covers the lateral surface(s) of each of the first light-emitting part 120, the second light-emitting part 130, the element substrate 140, the first phosphor layer 170, and the second phosphor layer 180. The light shielding member 190 preferably has a high light shielding property. As used herein, the term "light shielding property" refers to a property of transmitting substantially no light. Examples of the property of transmitting substantially no light include a property of blocking light, a property of absorbing light, and a property of reflecting light. The light shielding member 190 preferably has light reflectivity. For example, the light shielding member 190 preferably has a reflectance of 60% or more, and more preferably has a reflectance of 70% or more, 80% or more, or 90% or more with respect to light emitted from the light source 100.

The light shielding member 190 includes, for example, light reflective particles and an insulating base. The light reflective particles are particles having light reflectivity with respect to the first light L1, the second light L2, the third light L3, and the fourth light L4. The material of the light reflective particles is, for example, titanium oxide, zirconium oxide, boron nitride, or aluminum oxide. The light reflective particles can include at least one of them. The insulating base may be composed of an organic material, may be composed of an inorganic material, or may be composed of both an organic material and an inorganic material. As an example of the organic material, a resin such as a silicone resin can be used. As an example of the inorganic material, an alkali metal silicate can be used.

The light shielding member 190 reflects the first light L1, the second light L2, the third light L3, and the fourth light L4, which have reached the light shielding member 190, upward. Because the light source 100 includes the light shielding member 190, the light extraction efficiency of light extracted from the upper surface of the wavelength conversion member 160 can be improved.

### <Examples>

Next, optical simulations performed by using optical models of the light source 100 will be described. The light source 100 will be described in more detail by using simulation results of four optical models of Example 1 to Example 4. However, the scope of the present disclosure is not limited to Example 1 to Example 4.

Wavelength conversion members 160 in Example 1 to Example 4 have the following configurations. However, first phosphor, second phosphor, third phosphor, and fourth phosphor are not limited to the following phosphors.
(1) Example 1:
   - A first phosphor layer 170 includes a yttrium aluminum garnet based phosphor (hereinafter referred to as a "YAG-based phosphor") as a first phosphor.
   - A second phosphor layer 180 includes a CCA-based phosphor as a second phosphor.
(2) Example 2:
   - A first phosphor layer 170 includes the YAG-based phosphor as a first phosphor and a SCASN-based phosphor as a third phosphor. In the first phosphor layer 170, the volume ratio of the YAG-based phosphor to the SCASN-based phosphor was 22:3.
   - A second phosphor layer 180 includes the CCA-based phosphor as a second phosphor.
(3) Example 3:
   - A first phosphor layer 170 includes the YAG-based phosphor as a first phosphor, the SCASN-based phosphor as a third phosphor, and a KSF-based phosphor as a fourth phosphor. In the first phosphor layer 170, the volume ratio of the YAG-based phosphor, the SCASN-based phosphor, and the KSF-based phosphor was 20:2:10.
   - A second phosphor layer 180 includes the CCA-based phosphor as a second phosphor.
(4) Example 4:
   - A first phosphor layer 170 includes the YAG-based phosphor as a first phosphor and the KSF-based phosphor as a fourth phosphor. In the first phosphor layer 170, the volume ratio of the YAG-based phosphor to the KSF-based phosphor was 10:90.
   - A second phosphor layer 180 includes the CCA-based phosphor as a second phosphor.

In each of Example 1 to Example 4, an emission spectrum when only the first light-emitting part 120 was caused to emit light and an emission spectrum when only the second light-emitting part 130 was caused to emit light were obtained by simulation. The peak emission wavelength of first light L1 emitted from the first light-emitting part 120 was set to 450 nm. The peak emission wavelength of second light L2 emitted from the second light-emitting part 130 was set to 380 nm.

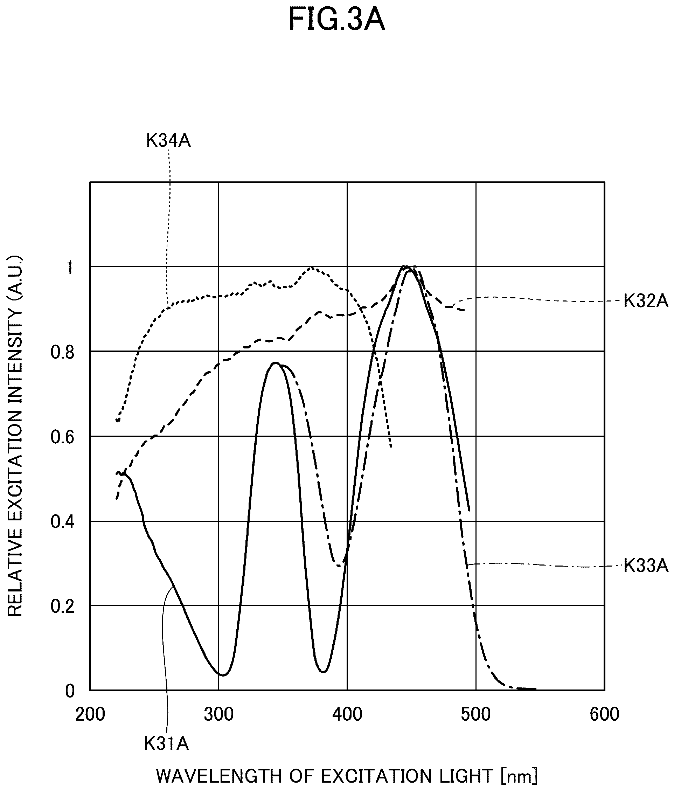

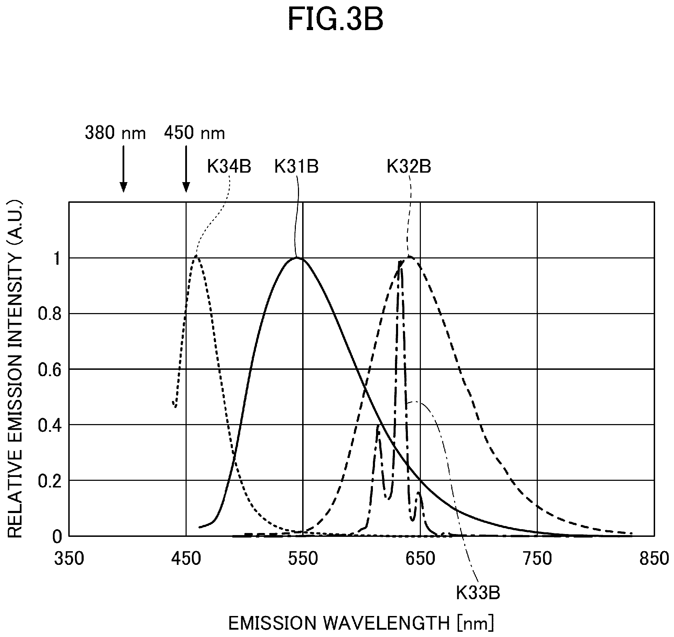

As a premise, excitation characteristics and light-emission characteristics of the YAG-based phosphor, the SCASN-based phosphor, the KSF-based phosphor, and the CCA-based phosphor will be described with reference to FIG. 3A and FIG. 3B. FIG. 3A illustrates an excitation spectrum of each of the YAG-based phosphor, the SCASN-based phosphor, the KSF-based phosphor, and the CCA-based phosphor. The horizontal axis of FIG. 3A represents a wavelength of excitation light that excites each of the phosphors. The vertical axis of FIG. 3A represents an excitation intensity (a relative excitation intensity) of each of the phosphors according to the wavelength of the excitation light. The excitation intensity of each of the phosphors indicated on the vertical axis of FIG. 3A is normalized by the peak value of the excitation intensity of each of the phosphors.

FIG. 3B illustrates an emission spectrum of each of the YAG-based phosphor, the SCASN-based phosphor, the KSF-based phosphor, and the CCA-based phosphor. The horizontal axis of FIG. 3B represents an emission wavelength of each of the phosphors. The vertical axis of FIG. 3B represents an emission intensity (a relative emission intensity) of each of the phosphors according to the emission wavelength. The emission intensity of each of the phosphors indicated on the vertical axis of FIG. 3B is normalized by the peak value of the emission intensity of each of the phosphors.

First, an example of excitation characteristics of each of the YAG-based phosphor, the SCASN-based phosphor, the KSF-based phosphor, and the CCA-based phosphor will be described with reference to FIG. 3A. As illustrated in FIG. 3A, in the case of the YAG-based phosphor indicated by line K31A, the excitation intensity at the peak emission wavelength of the second light L2, that is, at 380 nm, is lower than the excitation intensity at the peak emission wavelength of the first light L1, that is, at 450 nm. Similar to the YAG-based phosphor, in the case of each of the SCASN-based phosphor indicated by line K32A and the KSF-based phosphor indicated by line K33A, the excitation intensity at the peak emission wavelength of the second light L2, that is, at 380 nm, is lower than the excitation intensity at the peak emission wavelength of the first light L1, that is, at 450 nm. Further, the excitation intensity of the SCASN phosphor at the peak emission wavelength of the second light L2 is higher than the excitation intensity of the YAG phosphor at the peak emission wavelength of the second light L2. In contrast, in the case of the CCA-based phosphor indicated by line K34A, the excitation intensity at the peak emission wavelength of the first light L1 is lower than the excitation intensity at the peak emission wavelength of the second light L2.

Next, an example of light-emission characteristics of each of the YAG-based phosphor, the SCASN-based phosphor, the KSF-based phosphor, and the CCA-based phosphor will be described with reference to FIG. 3B. As illustrated in FIG. 3B, light from the YAG-based phosphor indicated by line K31B includes light in a wide wavelength range from about 460 nm to about 750 nm. Light from the SCASN-based phosphor indicated by line K32B includes light in a wide wavelength range from about 550 nm to about 800 nm. Light from the KSF-based phosphor indicated by line K33B includes light in a wavelength range on the long wavelength side from about 600 nm to about 650 nm. Light from the CCA-based phosphor indicated by line K34B includes light in a wavelength range from about 450 nm to about 550 nm. As illustrated in FIG. 3B, the peak emission wavelength of the light from the CCA-based phosphor is shorter than the peak emission wavelength of the light from the YAG-based phosphor and the peak emission wavelength of the light from the SCASN-based phosphor.

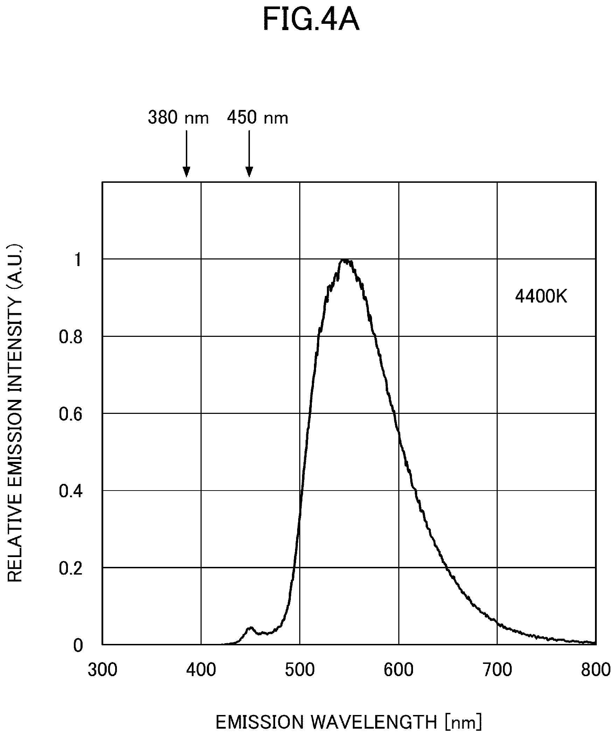

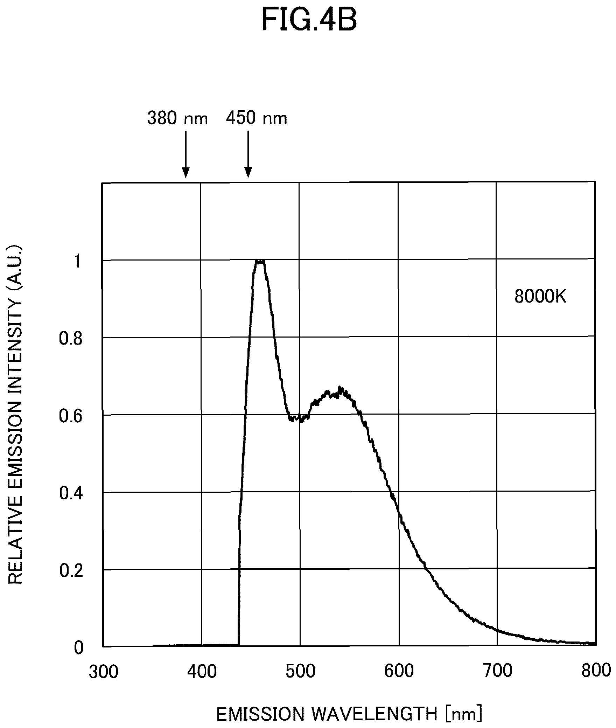

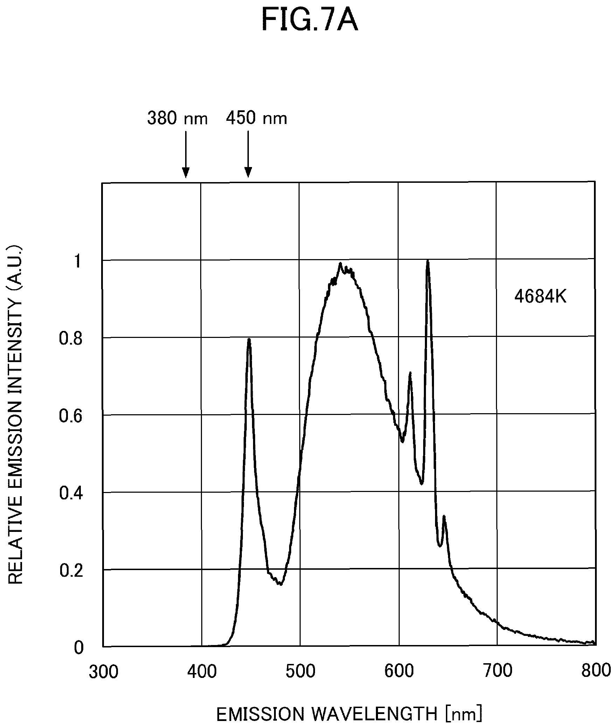

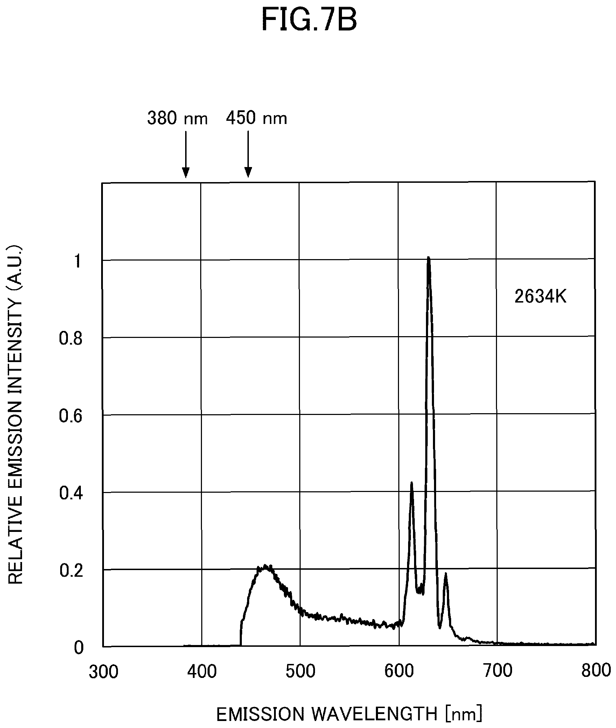

Next, simulation results of Example 1 to Example 4 will be described with reference to FIG. 4A to FIG. 7B. Each of FIG. 4A, FIG. 5A, FIG. 6A, and FIG. 7A illustrates a simulation result when only the first light-emitting part 120 was caused to emit light. Each of FIG. 4B, FIG. 5B, FIG. 6B, and FIG. 7B illustrates a simulation result when only the second light-emitting part 130 was caused to emit light.

In Example 1, the color temperature of light emitted from the light source 100 when only the first light-emitting part 120 was caused to emit light was 4,400 K, and the color temperature of light emitted from the light source 100 when only the second light-emitting part 130 was caused to emit light was 8,000 K. The results indicated that, when the first phosphor layer 170 includes the YAG-based phosphor as the first phosphor and the second phosphor layer 180 includes the CCA-based phosphor as the second phosphor, the color temperature of white light obtained by mixing third light L3 and fourth light L4 was able to be adjusted in a wide range at least from 4,400 K to 8,000 K.

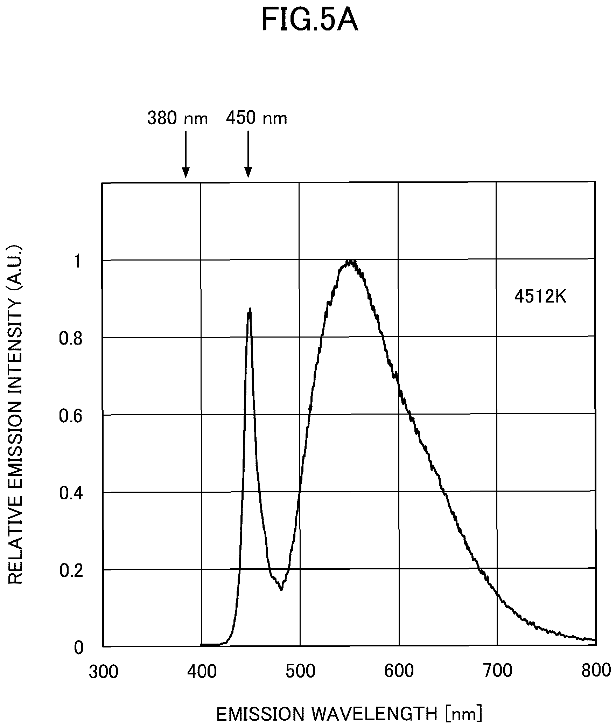

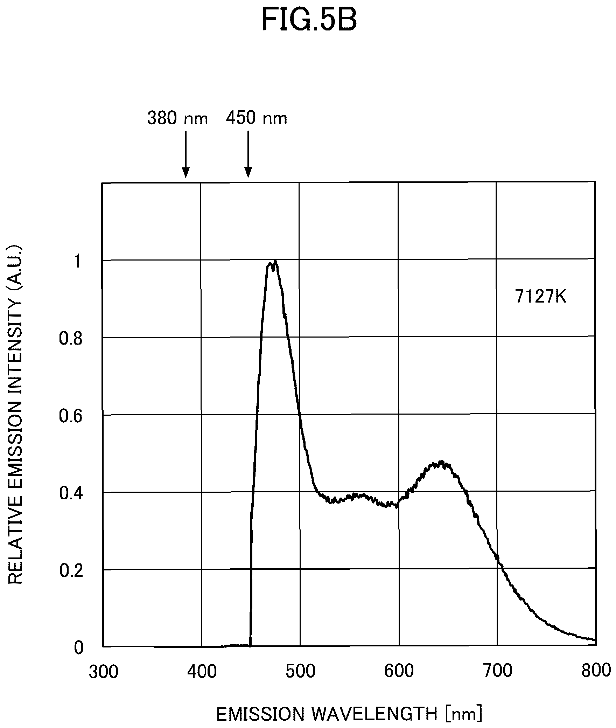

In Example 2, the color temperature of light emitted from the light source 100 when only the first light-emitting part 120 was caused to emit light was 4,512 K, and the color temperature of light emitted from the light source 100 when only the second light-emitting part 130 was caused to emit light was 7,127 K. The results indicated that, when the first phosphor layer 170 includes the YAG-based phosphor as the first phosphor and the SCASN-based phosphor as the third phosphor, and the second phosphor layer 180 includes the CCA-based phosphor as the second phosphor, the color temperature of white light, in which third light L3 and fourth light L4 were mixed, was able to be adjusted in a wide range at least from 4,512 K to 7,127 K. Further, as illustrated in FIG. 5A and FIG. 5B, causing the first phosphor layer 170 to include the SCASN-based phosphor as the third phosphor can increase, for example, the emission intensity in a wavelength range longer than 640 nm as compared to that of Example 1. That is, the results indicated that the color rendering property of the light emitted from the light source 100 was improved because of the mixed-color light from the light source 100 including light in a wavelength range on the longer wavelength side. In addition, the results indicated that the wavelength range of light reflected by an object, of the mixed-color light emitted from the light source 100, was also extended to the long wavelength side.

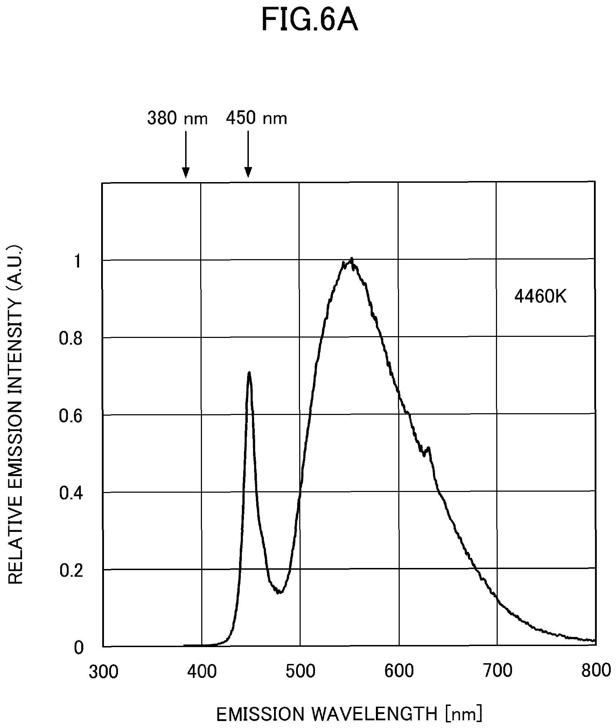

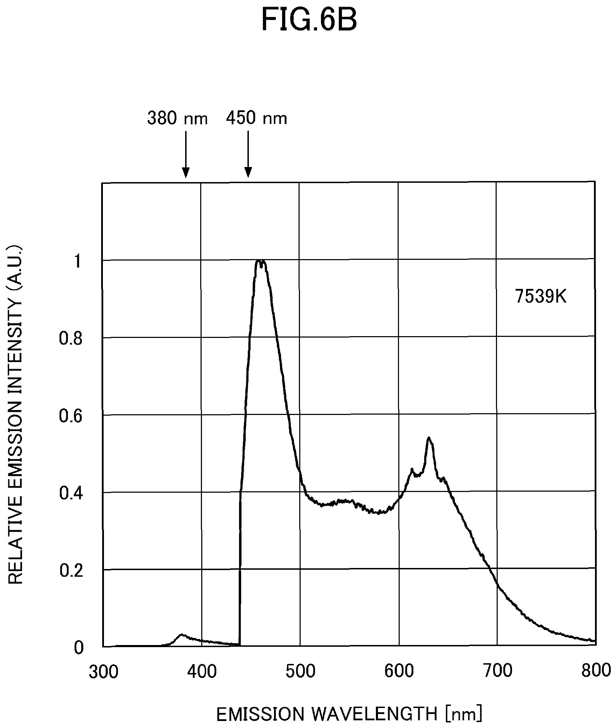

In Example 3, the color temperature of light emitted from the light source 100 when only the first light-emitting part 120 was caused to emit light was 4,460 K, and the color temperature of light emitted from the light source 100 when only the second light-emitting part 130 was caused to emit light was 7,539 K. The results indicated that when the first phosphor layer 170 includes the KSF-based phosphor in addition to the YAG-based phosphor and the SCASN-based phosphor, the color temperature of white light, in which third light L3 and fourth light L4 were mixed, was able to be adjusted in a wide range at least from 4,460 K to 7,539 K. Further, as illustrated in FIG. 6B, by causing the first phosphor layer 170 to include the KSF-based phosphor having a lower excitation intensity than that of the SCASN-based phosphor at the peak emission wavelength of the second light L2, the color temperature of the light emitted from the light source 100 when only the second light-emitting part 130 was caused to emit light was able to be increased as compared to that of Example 2. As a result, in Example 3, the color temperature range of the white light, in which the third light L3 and the fourth light L4 were mixed, was able to be expanded as compared to that of Example 2.

In Example 4, the color temperature of light emitted from the light source 100 when only the first light-emitting part 120 was caused to emit light was 4,684 K, and the color temperature of light emitted from the light source 100 when only the second light-emitting part 130 was caused to emit light was 2,634 K. In Example 4, the first phosphor layer 170 includes the YAG-based phosphor and the KSF-based phosphor and includes no SCASN-based phosphor. Accordingly, the color temperature of the light emitted from the light source 100 when only the second light-emitting part 130 was caused to emit light was within the color temperature range of warm white (from 2,600 K to 3,250 K) defined in JIS Z9112. That is, in Example 4, the results indicated that the color temperature of white light, in which third light L3 and fourth light L4 were mixed, was able to be adjusted in a wide range at least from 2,634 K to 4,684 K.

### [Second Embodiment]

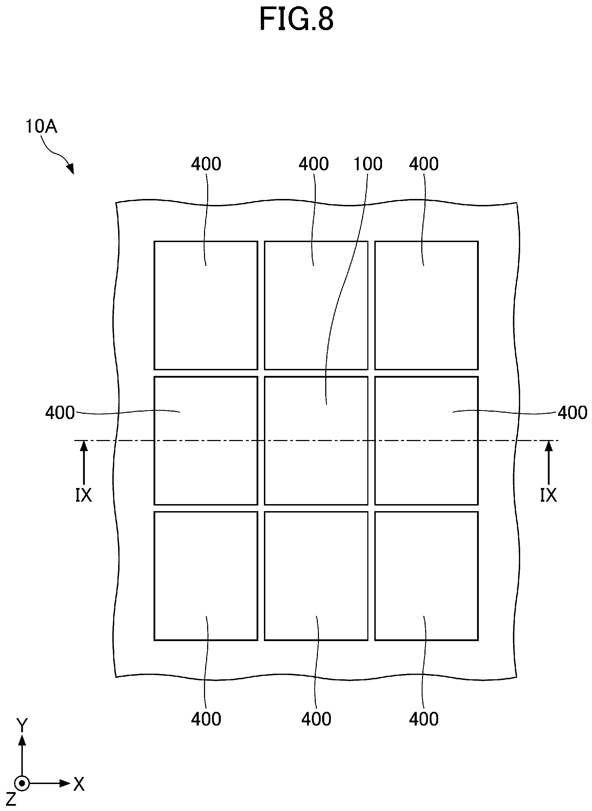

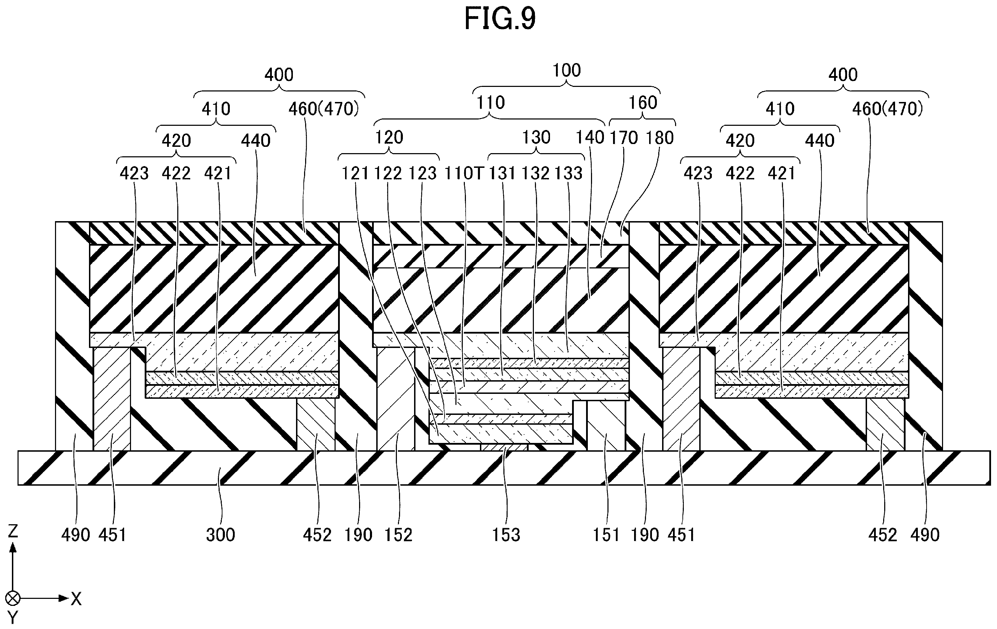

Next, a light-emitting module 10A according to a second embodiment will be described with reference to FIG. 8 and FIG. 9. FIG. 8 is a top view schematically illustrating the upper surface of the light-emitting module 10A according to the second embodiment. FIG. 9 is a schematic cross-sectional view of the light-emitting module 10A according to the second embodiment, taken through line IX-IX of FIG. 8. In the second embodiment, the same components as those in the first embodiment are denoted by the same reference numerals, and the description thereof will be omitted as appropriate. For convenience of description, in FIG. 8 and FIG. 9, a light source 100 and a second light source 400 included in the light-emitting module 10A are depicted, and a lens 200 is not depicted.

The light-emitting module 10A according to the second embodiment includes the light source 100, the second light source 400, and the lens 200. The lens 200 may have a configuration the same as or similar to the configuration of the lens 200 described with reference to FIG. 2 and the like. A lens part 210 of the lens 200 is disposed above the light source 100 and the second light source 400. The light-emitting module 10A may further include a substrate 300 supporting the light source 100, the second light source 400, and the lens 200.

Similar to the light-emitting module 10 according to the first embodiment, the light-emitting module 10A may be included in the mobile terminal 1 including the imaging element 3. That is, the light-emitting module 10A may be used as a light-emitting module for a flash, which is configured to emit irradiation light on a subject.

The light source 100 is the same as or similar to the light source 100 included in the light-emitting module 10 according to the first embodiment described with reference to FIG. 1 to FIG. 7. That is, the light source 100 includes the light-emitting element 110 and the wavelength conversion member 160. To distinguish the light source 100 from the second light source 400, the light source 100 is hereinafter referred to as a "first light source 100." Further, the light-emitting element 110 and the wavelength conversion member 160 are hereinafter referred to as a "first light-emitting element 110" and a "first wavelength conversion member 160," respectively.

As illustrated in FIG. 8 and FIG. 9, the light-emitting module 10A includes, for example, a plurality of second light sources 400. As illustrated in FIG. 9, the plurality of second light sources 400 are disposed around the first light source 100 in a top view. That is, the plurality of second light sources 400 are disposed so as to surround the first light source 100 in a top view.

In the example illustrated in FIG. 8, eight second light sources 400 are disposed around one first light source 100. The area of each of the second light sources 400 in a top view is substantially the same as the area of the first light source 100 in a top view. However, the number, the position, and the area of the first light source 100 in a top view, and the number, the position, and the area of the second light sources 400 in a top view are not limited to the example illustrated in FIG. 8, and can be changed as appropriate.

As illustrated in FIG. 9, each of the second light sources 400 includes a second light-emitting element 410 and a second wavelength conversion member 460. Each of the second light sources 400 may further include a light shielding member 490 covering the lateral surface(s) of the second light-emitting element 410 and the lateral surface(s) of the second wavelength conversion member 460. Each of the second light sources 400 may further include other components such as a light transmissive member covering the upper surface of the second wavelength conversion member 460. For convenience of description, the light transmissive member covering the upper surface of the second wavelength conversion member 460 is not depicted.

The second light-emitting element 410 includes a light-emitting part 420. The light-emitting part 420 may be a light-emitting part corresponding to the first light-emitting part 120 or the second light-emitting part 130 included in the first light-emitting element 110 of the first light source 100.

As illustrated in FIG. 9, the light-emitting part 420 is a semiconductor structure including a first semiconductor layer 421, a light-emitting layer 422, and a second semiconductor layer 423. As illustrated in FIG. 9, the first semiconductor layer 421, the light-emitting layer 422, and the second semiconductor layer 423 are stacked in this order in the first direction Z. The first semiconductor layer 421 and the second semiconductor layer 423 are of different conductivity types. In the example illustrated in FIG. 9, the first semiconductor layer 421 is formed of a p-type semiconductor, and the second semiconductor layer 423 is formed of an n-type semiconductor. However, alternatively, the first semiconductor layer 421 may be formed of an n-type semiconductor, and the second semiconductor layer 423 may be formed of a p-type semiconductor. The light-emitting layer 422 may have a single quantum well (SQW) structure or a multiple quantum well (MQW) structure including a plurality of well layers.

Similar to the first light-emitting part 120 or the second light-emitting part 130, each of the first semiconductor layer 421, the light-emitting layer 422, and the second semiconductor layer 423 may be formed of a nitride semiconductor including a semiconductor of all compositions obtained by varying the composition ratio x and y within their ranges in the chemical formula InₓAl_{y}Ga_{1-x-y}N (0 ≤ x, 0 ≤ y, x + y ≤ 1). For example, similar to the light-emitting layer 122 of the first light-emitting part 120, light emitted from the light-emitting layer 422 may be blue light having a peak emission wavelength of 400 nm or more and 530 nm or less, more preferably 420 nm or more and 490 nm or less, and even more preferably 440 nm or more and 460 nm or less. However, the peak emission wavelength of the light emitted from the light-emitting layer 422 is not limited thereto. Further, a semiconductor forming each of the first semiconductor layer 421, the light-emitting layer 422, and the second semiconductor layer 423 is not limited to the nitride semiconductor.

The second light-emitting element 410 may further include another light-emitting part configured to emit light having a peak emission wavelength different from the peak emission wavelength of the light emitted from the light-emitting part 420. The other light-emitting part may be a light-emitting part corresponding to the first light-emitting part 120 or the second light-emitting part 130 included in the first light-emitting element 110 of the first light source 100.

The second light-emitting element 410 may further include other components such as an element substrate 440, a first electrode 451, and a second electrode 452. The element substrate 440 is a light transmissive substrate disposed between the light-emitting part 420 and the second wavelength conversion member 460.

The first electrode 451 is connected to the second semiconductor layer 423 of the light-emitting part 420. The second electrode 452 is connected to the first semiconductor layer 421 of the light-emitting part 420. The first electrode 451 functions as a cathode electrode of the light-emitting part 420. The second electrode 452 functions as an anode electrode of the light-emitting part 420. The first electrode 451 and the second electrode 452 may be composed of a metal material or an alloy material the same as or similar to that of the electrodes of the first light-emitting element 110 of the first light source 100.

Each of the first electrode 451 and the second electrode 452 is connected to wiring of the substrate 300 directly or via an electrically-conductive bonding member. That is, each of the first electrode 451 and the second electrode 452 is connected to an external power supply circuit via the wiring of the substrate 300. Accordingly, the light-emitting part 420 is connected to the power supply circuit. The connection of the light-emitting part 420 to the power supply circuit can allow a control circuit included in the light-emitting module 10A to control the light emitting operation of the light-emitting part 420. The power supply circuit connected to the light-emitting part 420 may be a power supply circuit different from the power supply circuit connected to the first light-emitting element 110 of the first light source 100. The control circuit included in the light-emitting module 10A can individually control the light emitting operations of the first light source 100 and the second light sources 400.

The second wavelength conversion member 460 converts the wavelength of at least a portion of the light emitted from the light-emitting part 420 and emits light having a different wavelength. As illustrated in FIG. 9, the second wavelength conversion member 460 includes a phosphor layer 470. The phosphor layer 470 is disposed at a position higher than the second light-emitting element 410 and overlapping the second light-emitting element 410 in a top view. The second wavelength conversion member 460 may further include a phosphor layer different from the phosphor layer 470.

The phosphor layer 470 includes a light transmissive base and a phosphor. The light-transmissive base of the phosphor layer 470 may be the same as or similar to the light-transmissive base of each of the first phosphor layer 170 and the second phosphor layer 180 included in the first wavelength conversion member 160 of the first light source 100. Further, the phosphor of the phosphor layer 470 may be the same as or similar to any of the phosphors of the first phosphor layer 170 and the second phosphor layer 180.

For example, in a case where the light-emitting part 420 of the second light-emitting element 410 emits blue light, the phosphor layer 470 can include a phosphor such as a YAG-based phosphor that is excited by the blue light and emits yellow light. Accordingly, white light, in which the blue light and the yellow light are mixed, is emitted from the upper surface of the second wavelength conversion member 460. However, the phosphor included in the phosphor layer 470 is not limited to the YAG-based phosphor.

According to the second embodiment, the light-emitting module includes the first light source 100 and the second light sources 400, and thus the area of a light emitting region in a top view can be relatively increased. Accordingly, when the camera of the mobile terminal 1 including the imaging element 3 operates in a wide-angle photographing mode, light can be emitted to a subject over a wide angular range. Further, by making the configurations of the second light-emitting element 410 and the second wavelength conversion member 460 of each of the second light sources 400 the same as or similar to the configurations of the first light-emitting element 110 and the first wavelength conversion member 160 of the first light source 100, mixed-color light having reduced color unevenness and a color temperature adjusted to a desired color temperature can be emitted from each of the second light sources 400 in addition to the first light source 100. That is, mixed-color light having reduced color unevenness and a color temperature adjusted to a desired color temperature can be emitted over a wide angular range.

Further, according to the second embodiment, the light emitting operations of the first light source 100 and the second light sources 400 can be individually controlled. In addition, by making the number of light-emitting parts of the first light source 100 larger than the number of light emitting parts of each of the second light sources 400, light having a relatively high emission intensity can be emitted from the first light source 100 disposed at the center in a top view. Accordingly, when the camera of the mobile terminal 1 including the imaging element 3 operates in a telephoto mode, power consumption can be reduced and bright light can be emitted to a distant subject by causing only the first light source 100 to emit light.

As described above, according to the second embodiment, the emission intensity distribution of light emitted from the light-emitting module 10A can be varied according to the photographing mode of the camera. Specifically, when the camera operates in a wide-angle photographing mode, light can be emitted in a wide angular range, whereas when the camera operates in a telephoto mode, light having high emission intensity can be emitted in a narrow angular range. As a result, a subject within the angle of view of the camera operating in each photographing mode can be brightly irradiated with light.

Further, because the number of light-emitting parts of the first light source 100 is larger than the number of light-emitting parts of each of the second light source 400, light having partially high light emission intensity can be emitted. Therefore, the light-emitting module 10A can be suitably used as a flashlight.

According to one embodiment of the present disclosure, a light source capable of adjusting the color of mixed-color light can be reduced in size.

Although embodiments have been described in detail above, the above-described embodiments are nonlimiting examples, and various modifications and substitutions can be made to the above-described embodiments without departing from the scope described in the claims.

### DESCRIPTION OF THE REFERENCE NUMERALS

1 mobile terminal
2 housing
3 imaging element
10, 10A light-emitting module
100 light source (first light source)
110 light-emitting element (first light-emitting element)
120 first light-emitting part
130 second light-emitting part
140 element substrate
110T tunnel junction layer
151 first electrode
152 second electrode
153 third electrode
160 wavelength conversion member (first wavelength conversion member)
170 first phosphor layer
180 second phosphor layer
200 lens
210 lens part
220 support part
300 substrate
400 second light source
410 second light-emitting element
460 second wavelength conversion member

## Claims

1. A light source comprising:
a light-emitting element comprising:
a first light-emitting part configured to emit first light, and
a second light-emitting part configured to emit second light having a peak emission wavelength different from a peak emission wavelength of the first light, wherein:
the first light-emitting part and the second light-emitting part are stacked in a first direction, and
each of the first light-emitting part and the second light-emitting part comprises a first semiconductor layer, a light-emitting layer, and a second semiconductor layer; and
a wavelength conversion member disposed on the light-emitting element, the wavelength conversion member comprising:
a first phosphor layer configured to be excited by the first light and emit third light, and
a second phosphor layer configured to be excited by the second light and emit fourth light having a peak emission wavelength different from a peak emission wavelength of the third light, wherein:
the first phosphor layer and the second phosphor layer are stacked in the first direction.

2. The light source according to claim 1, wherein:
the peak emission wavelength of the second light is shorter than the peak emission wavelength of the first light, and
the second light-emitting part is located closer to the wavelength conversion member than the first light-emitting part is.

3. The light source according to claim 1 or 2, wherein:
the first phosphor layer comprises a first phosphor having a lower excitation intensity at the peak emission wavelength of the second light than at the peak emission wavelength of the first light, and
the second phosphor layer comprises a second phosphor having a lower excitation intensity at the peak emission wavelength of the first light than at the peak emission wavelength of the second light.

4. The light source according to claim 3, wherein:
a peak emission wavelength of the second phosphor is shorter than a peak emission wavelength of the first phosphor, and
the first phosphor layer is located closer to the light-emitting element than the second phosphor layer is.

5. The light source according to claim 3 or 4, wherein:
the first phosphor layer further comprises a third phosphor having a peak emission wavelength different from a peak emission wavelength of the first phosphor,
an excitation intensity of the third phosphor at the peak emission wavelength of the second light is higher than the excitation intensity of the first phosphor at the peak emission wavelength of the second light, and
the peak emission wavelength of the third phosphor is longer than the peak emission wavelength of the first phosphor.

6. The light source according to any one of claims 1 to 5, further comprising:
a control circuit configured to individually control the first light-emitting part and the second light-emitting part.

7. The light source according to any one of claims 1 to 6, wherein:
the light source is configured to emit white light in which the third light and the fourth light are mixed, and
a color temperature of the white light emitted from the light source is 2,000 K or more and 8,000 K or less.

8. A light-emitting module comprising:
a first light source; and
a lens disposed above the first light source,
wherein:
the first light source comprises:
a first light-emitting element comprising:
a first light-emitting part configured to emit first light, and
a second light-emitting part configured to emit second light having a peak emission wavelength different from a peak emission wavelength of the first light, wherein:
the first light-emitting part and the second light-emitting part are stacked in a first direction, and
each of the first light-emitting part and the second light-emitting part comprises a first semiconductor layer, a light-emitting layer, and a second semiconductor layer, and
a first wavelength conversion member disposed on the first light-emitting element, the first wavelength conversion member comprising:
a first phosphor layer configured to be excited by the first light to emit third light, and
a second phosphor layer configured to be excited by the second light to emit fourth light having a peak emission wavelength different from a peak emission wavelength of the third light, wherein:
the first phosphor layer and the second phosphor layer are stacked in the first direction.

9. The light-emitting module according to claim 8, further comprising:
one or more second light sources disposed around the first light source when viewed in the first direction, each of the one or more second light sources comprising:
a second light-emitting element comprising at least one of a first light-emitting part or a second light-emitting part, and
a second wavelength conversion member disposed on the second light-emitting element.

10. The light-emitting module according to claim 8 or 9, wherein:
the one or more second light sources include a plurality of second light sources disposed so as to surround the first light source when viewed in the first direction.

11. A mobile terminal comprising:
an imaging element configured to capture an image of a subject; and
a light-emitting module configured to emit irradiation light on the subject, wherein:
the light-emitting module comprises:
a first light source, and
a lens disposed above the first light source, and
the first light source comprises:
a first light-emitting element comprising
a first light-emitting part configured to emit first light, and
a second light-emitting part configured to emit second light having a peak emission wavelength different from a peak emission wavelength of the first light, wherein:
the first light-emitting part and the second light-emitting part are stacked in a first direction, and
each of the first light-emitting part and the second light-emitting part comprises a first semiconductor layer, a light-emitting layer, a second semiconductor layer, and
a first wavelength conversion member disposed on the first light-emitting element, the first wavelength conversion member comprising:
a first phosphor layer configured to be excited by the first light to emit third light, and
a second phosphor layer configured to be excited by the second light to emit fourth light having a peak emission wavelength different from a peak emission wavelength of the third light, wherein:
the first phosphor layer and the second phosphor layer are stacked in the first direction.
